# EUROPÄISCHE PATENTSCHRIFT

(11) **EP 0 317 806 B1**
(45) Veröffentlichungstag und Bekanntmachung des Hinweises auf die Patenterteilung: **25.05.1994**
(21) Anmeldenummer: 88118351.1
(22) Anmeldetag: 04.11.1988
(51) Int. Cl.: H01L 29/93

(54) **Integrierte Schaltungsanordnung mit einer Kapazität**
Integrated-circuit device with a capacitor
Dispositif pour circuit intégré avec un capaciteur

(30) Priorität: 27.11.1987 DE 3740302
(43) Veröffentlichungstag der Anmeldung: 31.05.1989
(73) Patentinhaber: TEMIC TELEFUNKEN microelectronic GmbH, 74072 Heilbronn (DE)
(72) Erfinder: Kaiser, Reinhold, D-7100 Heilbronn (DE)
(74) Vertreter: Maute, Hans-Jürgen, Dipl.-Ing.

(56) Entgegenhaltungen:
- FR-A- 2 009 973
- FR-A- 2 014 235

## Beschreibung

Die Erfindung betrifft eine integrierte Schaltungsanordnung mit einer Kapazität, die durch einen pn-Übergang gebildet ist und die von anderen Bauelementen durch einen pn-Übergang separiert ist.

Integrierte Schaltungsanordnungen benötigen bekanntlich Kapazitäten. Diese Kapazitäten werden beispielsweise durch pn-Übergänge realisiert. An die Kapazitäten wird die Anforderung gestellt, daß sie eine hohe Güte aufweisen, damit sie z. B. für einen großen Frequenzbereich, für Schaltungen mit kleinen Betriebsströmen und für rauscharme Verstärker geeignet sind.

Aus der FR-A-2 009 973 ist ein Sperrschichtkondensator bekannt, der aus zwei entgegengesetzt dotierten, übereinanderliegenden Halbleiterzonen besteht. Beide Halbleiterzonen befinden sich in einer epitaktischen Schicht auf einem Halbleitersubstrat. Die untere der beiden Zonen steht durch eine zusätzliche Teilzone mit dem Substrat in Verbindung. Dieser Teil des Sperrschichtkondensators weist dadurch eine pilzförmige Formgebung auf. Umgeben ist der Sperrschichtkondensator von einer rahmenförmigen Separationszone, die von der Oberfläche der epitaktischen Schicht bis ins Substrat reicht und die die gleiche Dotierungsart wie das Substrat aufweist.

Der Erfindung liegt die Aufgabe zugrunde, eine Lösung anzugeben, wie Kapazitäten möglichst hoher Güte in einer integrierten Schaltungsanordnung realisiert werden können. Diese Aufgabe wird bei einer integrierten Schaltungsanordnung der eingangs erwähnten Art nach der Erfindung durch die kennzeichnenden Merkmale des Anspruchs 1 gelöst.

Die Erfindung wird im folgenden an einem Ausführungsbeispiel erläutert.

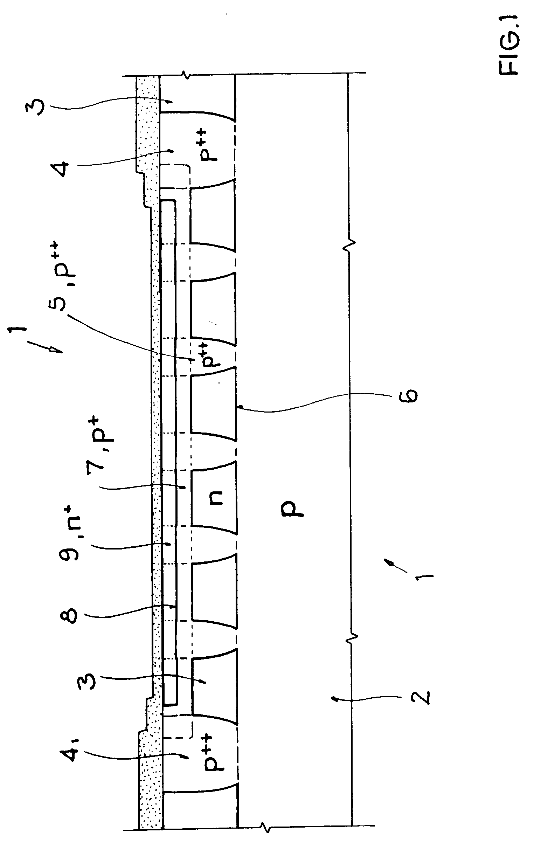

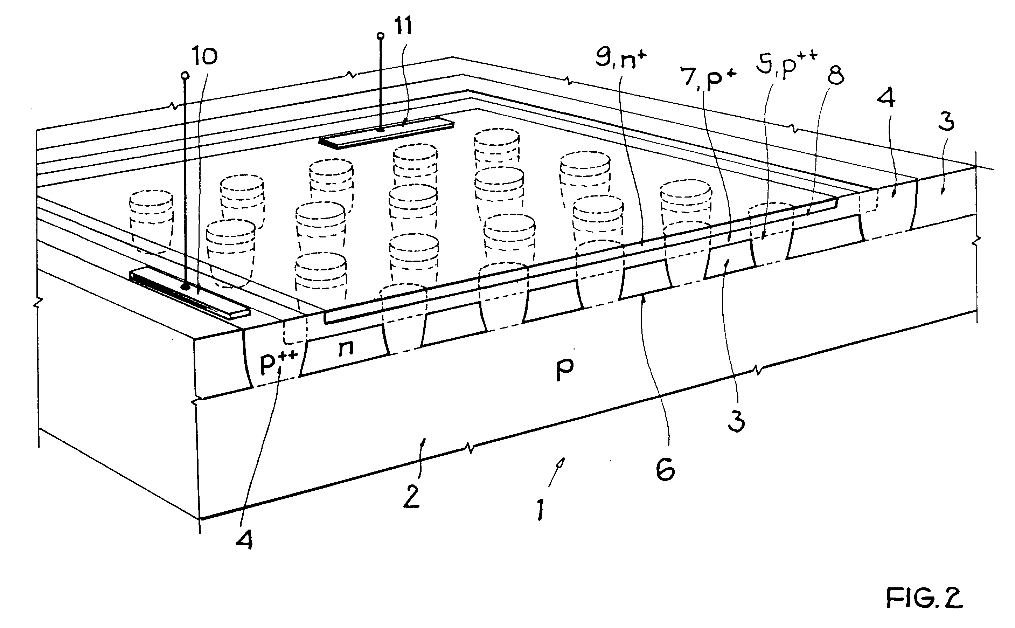

Die Figuren 1 und 2 zeigen eine integrierte Schaltungsanordnung nach der Erfindung im Schnitt und die Figur 2 zeigt eine solche Schaltungsanordnung zusätzlich noch in der Perspektive. Der Halbleiterkörper 1 der integrierten Schaltungsanordnungen der Figuren 1 und 2 besteht aus einem Substrat 2 vom ersten Leitungstyp und einer epitaktischen Schicht 3 vom zweiten Leitungstyp.

Im Ausführungsbeispiel der Figuren 1 und 2 hat das Substrat den p-Leitungstyp und die epitaktische Schicht 3 den n-Leitungstyp. Zur Separation der Kapazität wird in die epitaktische Schicht 3 eine Separationszone 4 eingebracht, die die Kapazität umgibt und rahmenförmig ausgebildet ist. Die Separationszone 4, die im Ausführungsbeispiel den p-Leitungstyp hat, wird beispielsweise durch Diffusion hergestellt.

Gleichzeitig mit der Herstellung der Separationszone 4 werden niederohmigen Bereiche 5 in die epitaktische Schicht eingebracht, und zwar in einem Arbeitsgang mit der Herstellung der Separationszone 4. Erfolgt die Herstellung der niederohmigen Bereiche 5 vom p-Leitungstyp gleichzeitig mit der Herstellung der Separationszone 4, so ist kein gesonderter Arbeitsgang erforderlich, sondern die Maske, die zur Herstellung der Separationszone 4 dient, enthält zusätzlich noch Öffnungen für die Herstellung der niederohmigen Bereiche 5. Erfolgt die Herstellung der Separationszone 4 durch Diffusion, so erfolgt die Herstellung der niederohmigen Bereiche 5 ebenfalls durch Diffusion im gleichen Arbeitsgang.

Die niederohmigen Bereiche 5 erstrecken sich von der Oberfläche der epitaktischen Schicht bis zum separierenden pn-Übergang 6, der durch die epitaktische Schicht 3 und das Substrat 2 gebildet wird. Die niederohmigen Bereiche 5 haben beispielsweise einen kreisförmigen oder einen rechteckförmigen Querschnitt.

Nach der Herstellung der Separationszone 4 und der niederohmigen Bereiche 5 wird in die epitaktische Schicht 3 eine Halbleiterzone 7 eingelassen, die eine der beiden den pn-Übergang 8 der Kapazität bildenden Halbleiterzonen ist. Die Halbleiterzone 7 hat im Ausführungsbeispiel den p-Leitungstyp und damit den Leitungstyp des Substrats. In die Halbleiterzone 7 wird gemäß den Figuren 1 und 2 die Halbleiterzone 9 eingelassen, die zusammen mit der Halbleiterzone 7 den pn-Übergang 8 der Kapazität bildet. Die Halbleiterzonen 7 und 9 werden beispielsweise durch Diffusion oder durch Ionenimplantation hergestellt.

Die niederohmigen Bereiche 5, die die Halbleiterzone 7 elektrisch mit dem Substrat 2 verbinden, haben im Ausführungsbeispiel einen kreisförmigen Querschnitt. Im allgemeinen wird jedoch aus konstruktionstechnischen Gründen ein rechteckförmiger Querschnitt bevorzugt. Die niederohmigen Bereiche 5 sind gemäß dem Ausführungsbeispiel über die gesamte Fläche der Kapazität verteilt. Wenn hier von Kapazität die Rede ist, so ist damit die gewünschte Kapazität gemeint, und nicht parasitäre Kapazitäten, die noch vorhanden sein können.

Durch die Art der Aufteilung der niederohmigen Bereiche 5 auf die Fläche der Kapazität sowie die Wahl der Abstände der niederohmigen Bereiche 5 voneinander kann die Frequenzabhängigkeit der Kapazität beeinflußt werden. Sind nur in einem bestimmten Teil der Fläche der Kapazität niederohmige Bereiche 5 vorhanden, so ist die Kapazität wesentlich frequenzabhängiger, als wenn die niederohmigen Bereiche 5 über die gesamte Fläche der Kapazität verteilt sind. Ebenso wird die Kapazität umso frequenzabhängiger, je größer der Abstand der niederohmigen Bereiche 5 voneinander ist.

Die niederohmigen Bereiche 5 sind im Bereich der Halbleiterzone 7 niederohmiger als der nicht von den niederohmigen Halbleiterbereichen 5 eingenommene Teil der Halbleiterzone 7. Die niederohmigen Bereiche 5 haben beispielsweise einen Flächenwiderstand von 20 Ohm/Flächeneinheit, während die Halbleiterzone 7 unter der Halbleiterzone 9 (zwischen der Halbleiterzone 9 und der nicht umdotierten Schicht 3) einen Flächenwiderstand von 5 - 10 kOhm/Flächeneinheit aufweist.

Die Halbleiterzone 7 erhält ihr Potential vom Substrat über die Separationszone 4 oder über die Elektrode 10, die sich auf der Oberfläche der Halbleiterzone 7 befindet. Die Halbleiterzone 9 wird durch die Elektrode 11 kontaktiert.

## Patentansprüche

1. Integrierte Schaltungsanordnung mit einer durch einen ersten pn-Übergang (8) gebildeten Kapazität, die durch einen zweiten pn-Übergang (4, 3) von anderen Bauelementen separiert ist, bestehend aus einem Substrat (2) des ersten Leitungstyps, einer auf dem Substrat (2) angeordneten epitaktischen Schicht (3) des zweiten Leitungstyps, einer ersten Halbleiterzone (7) des ersten Leitungstyps, die in die Oberfläche der epitaktischen Schicht (3) eingelassen ist, einer zweiten Halbleiterzone (9) des zweiten Leitungstyps, die in die Oberfläche der ersten Halbleiterzone (7) eingelassen ist und mit dieser den ersten pn-Übergang (8) bildet, und einer Separationszone (4) des ersten Leitungstyps, die sich von der Oberfläche der epitaktischen Schicht (3) bis in das Substrat (2) erstreckt und die durch die erste und zweite Halbleiterzone (7, 9) gebildete Kapazität umgibt und mit der epitaktischen Schicht (3) den zweiten pn-Übergang (4, 3) bildet, dadurch gekennzeichnet, daß eine Vielzahl von Halbleiterbereichen (5) des ersten Leitungstyps vorgesehen sind, die die erste Halbleiterzone (7) elektrisch mit dem Substrat (2) verbinden.

2. Integrierte Schaltungsanordnung nach Anspruch 1, dadurch gekennzeichnet, daß durch die Aufteilung der die elektrische Verbindung herstellenden Halbleiterbereiche (5) auf die Fläche der Kapazität und/oder durch deren Abstände voneinander die Frequenzabhängigkeit der Kapazität beeinflußt wird.

3. Integrierte Schaltungsanordnung nach Anspruch 1 oder 2, dadurch gekennzeichnet, daß die die elektrische Verbindung herstellenden Halbleiterbereiche (5) über die gesamte Fläche der Kapazität verteilt sind.

4. Integrierte Schaltungsanordnung nach Anspruch 1 oder 2, dadurch gekennzeichnet, daß die die elektrische Verbindung herstellenden Halbleiterbereiche (5) nur in einem Teil der Fläche der Kapazität vorgesehen sind.

5. Integrierte Schaltungsanordnung nach einem der Ansprüche 1 bis 4, dadurch gekennzeichnet, daß die Halbleiterbereiche (5) niederohmiger sind als die erste Halbleiterzone (7).

6. Integrierte Schaltungsanordnung nach einem der Ansprüche 1 bis 5, dadurch gekennzeichnet, daß die erste Halbleiterzone (7) die Separationszone (4) überlappt.

7. Integrierte Schaltungsanordnung nach einem der Ansprüche 1 bis 6, dadurch gekennzeichnet, daß die erste Halbleiterzone (7) ihr Potential über die Separationszone (4) und/oder über die Halbleiterbereiche (5) erhält.

8. Verfahren zum Herstellen einer integrierten Schaltungsanordnung nach einem der Ansprüche 1 bis 7, gekennzeichnet durch folgende Verfahrensschritte:
- auf einem Substrat (2) des ersten Leitungstyps wird eine epitaktische Schicht (3) vom zweiten Leitungstyp aufgebracht,
- in die epitaktische Schicht (3) werden in einem Arbeitsgang sowohl eine rahmenförmige Separationszone (4) als auch eine Vielzahl von Halbleiterbereichen (5) innerhalb der rahmenförmigen Separationszone (4) eingebracht, wobei die Zonen (4, 5) den ersten Leitungstyp aufweisen und von der Oberfläche der epitaktischen Schicht (3) bis zum Substrat reichen,
- innerhalb der rahmenförmigen Separationszone (4) wird in die epitaktische Schicht (3) eine erste Halbleiterzone (7) vom ersten Leitungstyp eingelassen, die durch die Vielzahl der Halbleiterbereiche (5) mit dem Substrat verbunden ist,
- in die erste Halbleiterzone (7) wird eine zweite Halbleiterzone (8) vom zweiten Leitungstyp eingelassen, die mit der ersten Halbleiterzone eine durch den pn-Übergang gebildete Kapazität ergibt.

9. Verfahren nach Anspruch 8, dadurch gekennzeichnet, daß die in die epitaktische Schicht (3) eingelassene erste Halbleiterzone (7) der Kapazität zusammen mit der Basiszone von Transistoren hergestellt wird, und daß die zweite Halbleiterzone (8) der Kapazität zusammen mit der Emitterzone von Transistoren hergestellt wird.

10. Verfahren nach Anspruch 8 oder 9, dadurch gekennzeichnet, daß die Separationszone (4) und die Vielzahl von Halbleiterbereichen (5) durch Diffusion hergestellt werden.

## Claims

1. Integrated circuit arrangement having a capacitance formed by a first pn junction (8), which is separated from other components by a second pn junction (4, 3), consisting of a substrate (2) of the first conductivity type; an epitaxial layer (3) of the second conductivity type arranged on the substrate (2), a first semiconductor zone (7) of the first conductivity type which is set into the surface of the epitaxial layer (3), a second semiconductor zone (9) of the second conductivity type which is set into the surface of the first semiconductor zone (7) and forms with the latter the first pn junction (8), and a separation zone (4) of the first conductivity type which extends from the surface of the epitaxial layer (3) into the substrate (2) and which surrounds the capacitance formed by the first and second semiconductor zone (7, 9) and which forms, together with the epitaxial layer (3), the second pn junction (4, 3), characterised in that, there are provided a plurality of semiconductor regions (5) of the first conductivity type which electrically connect the first semiconductor zone (7) to the substrate (2).

2. Integrated circuit arrangement in accordance with Claim 1, characterised in that, the frequency dependence of the capacitance is influenced by the distribution of the semiconductor regions (5) producing the electrical connection over the surface area of the capacitance and/or by their separation from one another.

3. Integrated circuit arrangement in accordance with Claim 1 or 2, characterised in that, the semiconductor regions (5) producing the electrical connection are distributed over the whole surface area of the capacitance.

4. Integrated circuit arrangement in accordance with Claim 1 or 2, characterised in that, the semiconductor regions (5) producing the electrical connection are only provided in a part of the surface area of the capacitance.

5. Integrated circuit arrangement in accordance with any of the Claims 1 to 4, characterised in that, the semiconductor regions (5) are of lower resistance than the first semiconductor zone (7).

6. Integrated circuit arrangement in accordance with any of the Claims 1 to 5, characterised in that, the first semiconductor zone (7) overlaps the separation zone (4).

7. Integrated circuit arrangement in accordance with any of the Claims 1 to 6, characterised in that, the first semiconductor zone (7) receives its potential via the separation zone (4) and/or via the semiconductor regions (5).

8. Method for the manufacture of an integrated circuit arrangement in accordance with any of the Claims 1 to 7, characterised by the following method steps:
- an epitaxial layer (3) of the second conductivity type is placed on a substrate (2) of the first conductivity type,
- both a frame like separation zone (4) and also a plurality of semiconductor regions (5) within the frame like separation zone (4) are inserted into the epitaxial layer (3) in one operation wherein the zones (4, 5) exhibit the first conductivity type and extend from the surface of the epitaxial layer (3) to the substrate,
- a first semiconductor zone (7) of the first conductivity type, which is connected to the substrate by the plurality of semiconductor regions (5), is set into the epitaxial layer (3) within the frame-like separation zone (4),
- a second semiconductor zone (8) of the second conductivity type, which, together with the first semiconductor zone, results in a capacitance formed by the pn junction, is set into the first semiconductor zone (7).

9. Method in accordance with Claim 8, characterised in that, the first semiconductor zone (7) of the capacitance which is set into the epitaxial layer (3) is manufactured together with the base zones of transistors, and that the second semiconductor zone (8) of the capacitance is manufactured together with the emitter zones of transistors.

10. Method in accordance with Claim 8 or 9, characterised in that, the separation zone (4) and the plurality of semiconductor regions (5) are produced by diffusion.

## Revendications

1. Circuit intégré comportant une capacité formée par une première jonction pn (8) et qui est séparé par une seconde jonction pn (4, 3) d'autres composants, comprenant un substrat (2) d'un premier type de conductivité, une couche épitactique (3) disposée sur le substrat (2) d'un second type de conductivité, une première zone de semi-conducteur (7) du premier type de conductivité, qui est formée dans la surface de la couche épitactique (3), une deuxième zone de semi-conducteur (9) du second type de conductivité, qui est formée dans la surface de la première zone de semi-conducteur (1) et constitue avec celle-ci la première jonction pn (8), ainsi qu'une zone de séparation (4), du premier type de conductivité, qui s'étend de la surface de la couche épitactique (3) jusque dans le substrat (2), entoure la capacité formée par la première et la deuxième zone de semi-conducteur (7, 9) et forme avec la couche épitactique (3) la seconde jonction pn (4, 3), caractérisé en ce qu'un grand nombre de régions de semi-conducteur (5) du premier type de conductivité est prévu, régions qui relient électriquement la première zone de semi-conducteur (7) au substrat (2).

2. Circuit intégré selon la revendication 1, caractérisé en ce que la variation de la capacité suivant la fréquence est influencée par la répartition sur l'aire de surface de la capacité des régions de semi-conducteur (5) établissant la liaison électrique et/ou par leurs espacements mutuels.

3. Circuit intégré selon la revendication 1 ou 2, caractérisé en ce que les régions de semi-conducteur (5), établissant la liaison électrique, sont réparties sur toute l'aire de surface de la capacité.

4. Circuit intégré selon la revendication 1 ou 2, caractérisé en ce que les régions de semi-conducteur (5), établissant la liaison électrique, sont seulement prévues dans une partie de l'aire de surface de la capacité.

5. Circuit intégré selon une des revendications 1 à 4, caractérisé en ce que les régions de semi-conducteur (5) sont de plus faible valeur ohmique que la première zone de semi-conducteur (7).

6. Circuit intégré selon une des revendications 1 à 5, caractérise en ce que la première zone de semi-conducteur (7) recouvre partiellement la zone de séparation (4).

7. Circuit intégré selon une des revendications 1 à 6, caractérisé en ce que la première zone de semi-conducteur (7) reçoit son potentiel à travers la zone de séparation (4) et/ou à travers les régions de semi-conducteur (5).

8. Procédé pour fabriquer un circuit intégré selon une des revendications 1 à 7, caractérisé par les étapes de procédé suivantes:
- application sur un substrat (2) du premier type de conductivité d'une couche épitactique (3) du second type de conductivité,
- formation dans la couche épitactique (3), en une seule opération, à la fois d'une zone de séparation (4) en forme de cadre et d'un grand nombre de régions de semi-conducteur (5), à l'intérieur de la zone de séparation (4) en forme de cadre, ces zones (4, 5) étant du premier type de conductivité et s'étendant depuis la surface de la couche épitactique (3) jusqu'au substrat,
- formation dans la couche épitactique (3), à l'intérieur de la zone de séparation (4) en forme de cadre, d'une première zone de semi-conducteur (7) du premier type de conductivité, reliée au substrat par le grand nombre de régions de semi-conducteur (5), et
- formation dans la première zone de semi-conducteur (7) d'une deuxième zone de semi-conducteur (9) du second type de conductivité, qui forme avec la première zone de semi-conducteur une capacité constituée par la jonction pn.

9. Procédé selon la revendication 8, caractérisé en ce que la première zone de semi-conducteur (7) de la capacité, formée dans la couche épitactique (3), est réalisée ensemble avec la zone de base de transistors, et que la deuxième zone de semi-conducteur (9) de la capacité est réalisée ensemble avec la zone d'émetteur de transistors.

10. Procédé selon la revendication 8 ou 9, caractérisé en ce que la zone de séparation (4) et le grand nombre de régions de semi-conducteur (5) sont réalisés par diffusion.
